# EUROPÄISCHE PATENTSCHRIFT

(11) **EP 1 078 460 B1**
(45) Veröffentlichungstag und Bekanntmachung des Hinweises auf die Patenterteilung: **28.11.2001**
(21) Anmeldenummer: 99929086.9
(22) Anmeldetag: 03.05.1999
(51) Int. Cl.: H03K 17/16

(54) **VERFAHREN UND VORRICHTUNG ZUM UMSCHALTEN EINES FELDEFFEKTTRANSISTORS**
METHOD AND DEVICE FOR SWITCHING A FIELD EFFECT TRANSISTOR
PROCEDE ET DISPOSITIF POUR COMMUTER UN TRANSISTOR A EFFET DE CHAMP

(30) Priorität: 12.05.1998 DE 19821232
(43) Veröffentlichungstag der Anmeldung: 28.02.2001
(73) Patentinhaber: Infineon Technologies AG, 81669 München (DE)
(72) Erfinder: EHBEN, Thomas, D-81379 München (DE)
(74) Vertreter: Zedlitz, Peter, Dipl.-Inf.
(86) Internationale Anmeldenummer: DE9901306
(87) Internationale Veröffentlichungsnummer: WO9959249

(56) Entgegenhaltungen:
- EP-A- 0 513 663
- EP-A- 0 587 999
- JP-A- 5 083 100
- US-A- 5 120 992
- US-A- 5 317 206
- US-A- 5 546 029

## Beschreibung

Die vorliegende Erfindung betrifft ein Verfahren gemäß dem Oberbegriff des Patentanspruchs 1 und eine Vorrichtung gemäß dem Oberbegriff des Patentanspruchs 3, d.h. ein Verfahren und eine Vorrichtung zum Umschalten eines Feldeffekttransistors vom sperrenden in den leitenden Zustand oder umgekehrt, wobei das Umschalten unter Anlegen einer zum Umschalten geeigneten Steuerspannung an ein dem Gateanschluß des Feldeffekttransistors vorgeschaltetes RC-Glied erfolgt.

Derartige Verfahren und Vorrichtungen werden insbesondere bei großen Treiberstufen (beispielsweise bei Ausgangstreibern) in integrierten CMOS-Schaltungen eingesetzt, um ein sprungartiges Umschalten von große Leistungen schaltenden Feldeffekttransistoren und die damit verbundenen Nachteile wie insbesondere das Auftreten von Versorgungsspannungsschwankungen und elektromagnetischen Störungen zu verhindern.

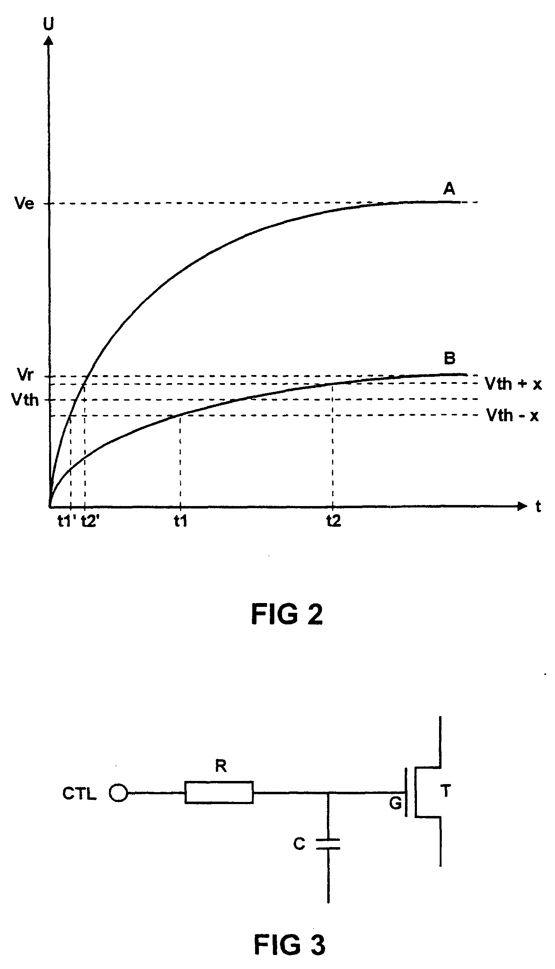

Ein Feldeffekttransistor mit einem dem Gateanschluß vorgeschalteten RC-Glied ist in Figur 3 dargestellt. Dabei sind der Feldeffekttransistor mit dem Bezugszeichen T, der Gateanschluß des Feldeffekttransistors T mit dem Bezugszeichen G, der Widerstand des RC-Gliedes mit dem Bezugszeichen R, der Kondensator des RC-Gliedes mit dem Bezugszeichen C, und der Anschluß, über welchen die den Feldeffekttransistor T steuernde Steuerspannung an dessen Gateanschluß G angelegt wird, mit dem Bezugszeichen CTL bezeichnet.

Das Ansteuern des Feldeffekttransistors über ein diesem (dessen Gateanschluß) vorgeschaltetes RC-Glied bewirkt, daß sich die Spannung am Gateanschluß des Feldeffekttransistors nur mehr oder weniger langsam, jedenfalls aber nicht sprungartig ändern kann, wodurch der Feldeffekttransistor auch nur vergleichsweise langsam umschalten kann.

Das Vorsehen von RC-Gliedern ist allerdings relativ aufwendig. Insbesondere RC-Glieder mit großen Zeitkonstanten belegen eine relativ große Fläche auf der integrierten Schaltung, was verständlicherweise einen erheblichen Nachteil darstellt.

Der vorliegenden Erfindung liegt daher die Aufgabe zugrunde, das Verfahren gemäß dem Oberbegriff des Patentanspruchs 1 und die Vorrichtung gemäß dem Oberbegriff des Patentanspruchs 3 derart weiterzubilden, daß ein sprungartiges Umschalten des Feldeffekttransistors mit minimalem technischen Aufwand zuverlässig verhinderbar ist.

Diese Aufgabe wird erfindungsgemäß durch die im kennzeichnenden Teil des Patentanspruchs 1 beanspruchten Merkmale (Verfahren) bzw. durch die im kennzeichnenden Teil des Patentanspruchs 3 beanspruchten Merkmale (Vorrichtung) gelöst.

Demnach ist vorgesehen,
- daß das Umschalten des Feldeffekttransistors unter Verwendung einer Steuerspannung durchgeführt wird, welche zumindest vorübergehend nur geringfügig jenseits der Schwellenspannung liegt, die an den Gateanschluß des Feldeffekttransistors angelegt werden muß, um ein Umschalten desselben bewirken zu können (kennzeichnender Teil des Patentanspruchs 1) bzw.
- daß die Vorrichtung dazu ausgelegt ist, das Umschalten des Feldeffekttransistors unter Verwendung einer Steuerspannung durchzuführen, welche zumindest vorübergehend nur geringfügig jenseits der Schwellenspannung liegt, die an den Gateanschluß des Feldeffekttransistors angelegt werden muß, um ein Umschalten desselben bewirken zu können (kennzeichnender Teil des Patentanspruchs 3).

Dadurch kann erreicht werden, daß die sich am Gateanschluß des Feldeffekttransistors einstellende Spannung insbesondere im Bereich der Schwellenspannung besonders langsam verändert, und zwar selbst dann, wenn das verwendete RC-Glied eine nur relativ geringe Zeitkonstante aufweist. Die sich am Gateanschluß des Feldeffekttransistors einstellende Spannung ist nämlich zugleich die Spannung, die sich am Kondensator des vorgeschalteten RC-Gliedes einstellt, und diese folgt Änderungen der Steuerspannung nur allmählich und nähert sich dieser im Endstadium (vor dem Erreichen derselben) besonders langsam an.

Damit läßt sich ein sprungartiges Umschalten des Feldeffekttransistors auf verblüffend einfache Weise und mit minimalem technischen Aufwand zuverlässig verhindern.

Vorteilhafte Weiterbildungen der Erfindung sind den Unteransprüchen, der folgenden Beschreibung und den Figuren entnehmbar.

Die Erfindung wird nachfolgend anhand eines Ausführungsbeispiels unter Bezugnahme auf die Zeichnung näher erläutert.
Es zeigen
- Figur 1: eine Treiberstufe mit einem Ausführungsbeispiel einer zur erfindungsgemäßen Feldeffekttransistor-Ansteuerung ausgelegten (Dämpfungs-)Schaltung,
- Figur 2: den Verlauf der sich bei unterschiedlichen Ansteuerungen des Feldeffekttransistors am Gateanschluß desselben einstellenden Spannung, und
- Figur 3: einen Feldeffekttransistor mit einem dem Gateanschluß vorgeschaltetem RC-Glied.

Der Feldeffekttransistor, dessen Schaltverhalten es zu beeinflussen gilt, ist im betrachteten Beispiel Bestandteil einer integrierten Schaltung; er kann aber auch als ein diskretes Bauelement realisiert sein. Entsprechendes gilt für die (Dämpfungs-)Schaltung, durch welche auf das Schaltverhalten des Feldeffekttransistors Einfluß genommen wird.

Die integrierte Schaltung, deren Bestandteil der Feldeffekttransistor und/oder die Dämpfungsschaltung sind, ist im betrachteten Beispiel eine CMOS-Schaltung; es könnte sich aber auch um eine reine NMOS- oder PMOS-Schaltung oder eine sonstige integrierte Schaltung handeln.

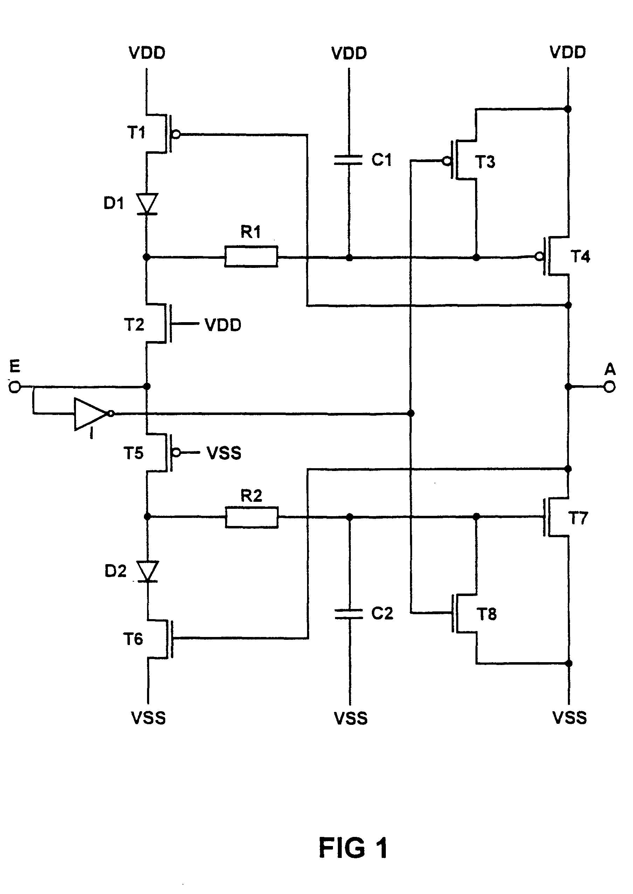

Der Feldeffekttransistor, dessen Schaltverhalten beeinflußt werden soll und die Dämpfungsschaltung, durch welche dies geschehen soll, sind im betrachteten Beispiel Bestandteil der in der Figur 1 gezeigten Treiberschaltung.

Die Treiberschaltung besteht aus PMOS-Transistoren T1, T3, T4 und T5, NMOS-Transistoren T2, T6, T7 und T8, Dioden D1 und D2, Widerständen R1 und R2, Kondensatoren C1 und C2, und einem Inverter I, welche wie in der Figur 1 gezeigt verschaltet sind. Die Kondensatoren C1 und C2 müssen nicht unbedingt separate Bauelemente sein; es kann sich dabei um die parasitären Kapazitäten der Transistoren T4 und T7 handeln.

Die Treiberschaltung wird mit einer Versorgungsspannung beaufschlagt, deren Pole die Potentiale VSS und VDD aufweisen, wobei VSS im betrachteten Beispiel das niedrigere Potential ist und beispielsweise 0 V beträgt, und wobei VDD im betrachteten Beispiel das höhere Potential ist und beispielsweise 5 V beträgt.

Die Treiberschaltung weist einen Eingangsanschluß E und einen Ausgangsanschluß A auf, wobei aus dem Ausgangsanschluß A ein Ausgangssignal mit niedrigem Pegel ausgegeben werden soll, wenn und so lange das in den Eingangsanschluß E eingegebene Eingangssignal einen hohen Pegel aufweist, und wobei aus dem Ausgangsanschluß A ein Ausgangssignal mit hohem Pegel ausgegeben werden soll, wenn und so lange das in den Eingangsanschluß E eingegebene Eingangssignal einen niedrigen Pegel aufweist; der niedrige Pegel möge dabei durch das niedrige Versorgungsspannungs-Potential VSS repräsentiert werden, und der hohe Pegel durch das hohe Versorgungsspannungs-Potential VDD.

Das aus dem Ausgangsanschluß A ausgegebene Ausgangssignal wird durch die Transistoren T4 und T7 erzeugt, wobei der Transistor T4 dazu ausgelegt ist, VDD auf den Ausgangsanschluß A durchzuschalten, und wobei der Transistor T7 dazu ausgelegt ist, VSS auf den Ausgangsanschluß A durchzuschalten; durch die Transistoren T3 und T8 wird sichergestellt, daß die Transistoren T4 und T7 nie gleichzeitig leitend sind.

Den Gateanschlüssen der Transistoren T4 und T7 sind Dämpfungsschaltungen vorgeschaltet, wobei die dem Transistor T4 zugeordnete Dämpfungsschaltung die Transistoren T1 und T2, die Diode D1, den Widerstand R1 und den Kondensator C1 umfaßt, und wobei die dem Transistor T7 zugeordnete Dämpfungsschaltung die Transistoren T5 und T6, die Diode D2, den Widerstand R2 und den Kondensator C2 umfaßt.

Die dem Transistor T4 vorgeschaltete Dämpfungsschaltung und die dem Transistor T7 vorgeschaltete Dämpfungsschaltung sind symmetrisch aufgebaut, weshalb im folgenden nur eine (die dem Transistor T7 vorgeschaltete Dämpfungsschaltung) beschrieben wird; die Ausführungen gelten für die andere Dämpfungsschaltung entsprechend.

Die dem Transistor T7 zugeordnete Dämpfungsschaltung setzt sich aus einem dem Gateanschluß des Transistors T7 vorgeschalteten RC-Glied und einem dem RC-Glied vorgeschalteten Spannungsteiler zusammen, wobei das RC-Glied aus dem Widerstand R1 und dem Kondensator C1 besteht, und wobei der Spannungsteiler aus den Transistoren T5 und T6 und der Diode D2 besteht.

Der Transistor T7 soll letztlich in Abhängigkeit von dem über den Eingangsanschluß E eingegebenen Eingangssignal arbeiten. Das Eingangssignal wird dem Gateanschluß des Transistors T7 jedoch nicht direkt, sondern über die diesem vorgeschaltete Dämpfungsschaltung zugeführt.

Dies wirkt sich auf die sich am Gateanschluß des Transistors T7 einstellende Spannung in zweifacher Hinsicht aus: einerseits werden im Eingangssignal vorhandene Flanken nur gedämpft an den Gateanschluß des Transistor T7 durchgeschaltet, und andererseits ist die durchgeschaltete Spannung niedriger als das Eingangssignal, wobei der erstgenannte Effekt durch das RC-Glied, und zweitgenannte Effekt durch den Spannungsteiler bewirkt wird.

Dimensioniert man den Spannungsteiler so, daß über diesen an das RC-Glied eine Spannung angelegt wird, die nur geringfügig jenseits der Schwellenspannung liegt, die an den Gateanschluß des Transistors T7 angelegt werden muß, um ein Umschalten desselben bewirken zu können, so kann dadurch erreicht werden, daß die sich am Gateanschluß des Transistors T7 einstellende Spannung im Bereich der Schwellenspannung besonders langsam verändert. Kondensatoren weisen nämlich die Eigenschaft auf, daß die sich an diesen einstellende Spannung mit zunehmender Annäherung an die Spannung, unter Verwendung welcher sie aufgeladen werden, immer langsamer verändern.

Die sich im Bereich der Schwellenspannung des Transistors T7 besonders langsam vollziehende Veränderung der sich am Gateanschluß des Transistors T7 einstellenden Spannung bewirkt, daß der Transistor T7 besonders langsam umschaltet, und zwar selbst dann, wenn das verwendete RC-Glied eine nur relativ geringe Zeitkonstante aufweist.

Zur genauen Erläuterung der Funktion und Wirkungsweise der Treiberschaltung gemäß Figur 1 werden nachfolgend die Vorgänge beschrieben, die nach einem Wechsel des in den Eingangsanschluß E eingegebenen Eingangssignals vom niedrigen Pegel auf den hohen Pegel ablaufen.

Es wird davon ausgegangen, daß das in den Eingangsanschluß E eingegebene Eingangssignal zunächst den niedrigen Pegel, und das aus dem Ausgangsanschluß A ausgegebene Ausgangssignal zunächst den hohen Pegel aufweist. Der Wechsel des Eingangssignals vom niedrigen auf den hohen Pegel bewirkt, daß durch den dann leitenden Transistor T5, die Diode D2 und den zumindest vorübergehend ebenfalls leitenden Transistor T6 ein Strom fließt. Der Transistor T6 ist zumindest vorübergehend leitend, da dessen Gatespannung, d.h. das über den Ausgangsanschluß A der Treiberschaltung ausgegebene Ausgangssignal zunächst noch mindestens um die Schwellenspannung des Transistors T6 größer ist als die an dessen Sourceanschluß anliegende Spannung; der über den Transistor T5, die Diode D2 und den Transistor T6 fließende Strom verursacht an der Diode D2 nämlich einen Spannungsabfall, der ungefähr so groß ist wie die Schwellenspannung des Transistors T6. Daß an der Diode D2 ein Spannungsabfall auftritt, der gerade etwa so groß ist wie die Schwellenspannung des Transistors T6, läßt sich beispielsweise dadurch erreichen, daß die Diode D2 als MOS-Diode, d.h. als Feldeffekttransistor realisiert wird, dessen Drain- und Gateanschluß miteinander verbunden sind.

Die sich an der Anode der Diode D2 einstellende Spannung ist die den Feldeffekttransistor T7 steuernde Steuerspannung, wobei, wie vorstehend bereits erwähnt wurde, die Steuerspannung nicht direkt an den Gateanschluß des Feldeffekttransistors, sondern an das diesem vorgeschaltete RC-Glied angelegt wird.

Das Anlegen der Steuerspannung an das RC-Glied bewirkt, daß dessen Kondensator C2 auf die Steuerspannung aufgeladen wird, wobei die sich am Kondensator C2 einstellende Spannung die Spannung ist, mit welcher der Gateanschluß des Transistors T7 beaufschlagt wird.

Das Laden des Kondensators erfolgt bekanntlich stark nichtlinear, wobei die Veränderung der sich am Kondensator einstellenden Spannung mit zunehmender Annäherung an die den Kondensator ladende Spannung (im betrachteten Beispiel die durch den Spannungsteiler reduzierte und nachfolgend mit Vr bezeichnete Steuerspannung) immer langsamer erfolgt.

Im oberen Bereich der Kondensator-Ladekurve, also in dem Bereich, wo diese den geringsten Gradienten hat, wird der Transistor T7 allmählich leitend und zieht die aus dem Ausgangsanschluß A der Treiberschaltung ausgegebene Ausgangsspannung allmählich nach unten. Da der Transistor T7 langsam angesteuert wird, vollzieht sich die Änderung der Ausgangsspannung ebenfalls nur relativ langsam; der Verlauf der Ausgangsspannung ist dadurch weitestgehend lastunabhängig und verursacht auch keine Versorgungsspannungs-Schwankungen.

Noch bevor die sich am Gateanschluß des Transistors T7 einstellende Spannung die Schwellenspannung Vth des Transistors T7 erreicht und ihn damit leitend werden läßt, wird über den Inverter I und den Transistor T3 der Gateanschluß des zum Transistor T7 komplementären Ausgangstransistors T4 entladen. Dadurch wird verhindert, daß die Transistoren T4 und T7 gleichzeitig leiten.

Mehr oder weniger kurz vor dem vollständigen Umschalten des Transistors T7, genauer gesagt wenn die Spannung am Ausgangsanschluß A nicht mehr ausreicht, um den Transistor T6 durchgeschaltet zu halten, wird dieser dadurch in den sperrenden Zustand versetzt, wodurch der Stromfluß über den Transistor T5, die Diode D2 und den Transistor T6 unterbunden wird. Dies kommt einer Deaktivierung des dem RC-Glied vorgeschalteten Spannungsteilers gleich: an das RC-Glied wird über den Transistor T5 fortan direkt das über den Eingangsanschluß E eingegebene Eingangssignal angelegt. Dadurch steigen die sich am Kondensator C2 und damit auch die sich am Gateanschluß des Transistors T7 einstellenden Spannung auf die im folgenden mit Ve bezeichnete Spannung des über den Eingangsanschluß E eingegebenen Eingangssignals an, wodurch der bereits durchgeschaltete Transistor T7 auch bei gegebenenfalls auftretenden Störungen (Spannungsschwankungen) sicher durchgeschaltet bleibt.

Die beschriebene Schaltung ist wegen ihres einfachen Aufbaus (insbesondere weil auf Regler mit Gegenkopplung der Ausgangsspannung verzichtet werden kann) äußerst stabil; die Transistoren werden vorzugsweise in Arbeitsbereichen betrieben, in denen sich Herstellungstoleranzen nicht oder möglichst wenig auf ihr Verhalten auswirken.

Den Verlauf der Spannung, die sich am Kondensator C2 des RC-Gliedes und damit auch am Gateanschluß des Transistors T7 bis zu dessen vollständigem Durchschalten einstellt, ist aus Figur 2, genauer gesagt aus der dort gezeigten Kurve B ersichtlich.

Wie aus der Kurve B der Figur 2 ersichtlich ist, steigt die sich am Kondensator C2 und damit auch am Gateanschluß des Transistors T7 einstellende Spannung ab dem Zeitpunkt t=0 mit abnehmender Steilheit auf die anfangs an das RC-Glied angelegte reduzierte Steuerspannung Vr an, welche im betrachteten Beispiel nur knapp oberhalb der (mit Vth bezeichneten) Schwellenspannung des Transistors T7 liegt; sie erreicht dabei zum Zeitpunkt t1 eine etwas unterhalb der Schwellenspannung Vth liegende Spannung Vth - x und zum Zeitpunkt t2 eine etwas oberhalb der Schwellenspannung Vth, aber noch unterhalb der reduzierte Steuerspannung Vr liegende Spannung Vth + x, wobei die Spannung Vth - x diejenige Spannung sei, bei welcher das Umschalten des Transistors T7 beginnen möge, und wobei die Spannung Vth + x diejenige Spannung sei, bei welcher das Umschalten des Transistors T7 beendet sein möge. Der Transistor T7 schaltet zwischen den Zeitpunkten t1 und t2 um, wobei die Zeitspanne zwischen t1 und t2 relativ lang ist und das Umschalten entsprechend langsam vonstatten geht.

Würde man das über den Eingangsanschluß E der Treiberschaltung gemäß Figur 1 eingegebene Signal wie bisher direkt (in voller Höhe) an das dem Gateanschluß des Transistors T7 vorgeschaltete RC-Glied anlegen, so würden sich die in der Kurve A der Figur 2 gezeigten Verhältnisse einstellen. D.h., die sich am Kondensator C2 und damit auch am Gateanschluß des Transistors T7 einstellende Spannung stiege auf die vergleichsweise sehr hohe Spannung Ve an und erreichte die Spannungen Vth - x und Vth + x zu den Zeitpunkten t1' bzw. t2', wobei die Zeitspanne zwischen t1' und t2' nur relativ kurz ist und das Umschalten des Transistors folglich erheblich schneller vonstatten geht als es bei der Kurve B der Fall ist.

Auf die beschriebene Art und Weise läßt sich ein sprungartiges Umschalten des Feldeffekttransistors auf verblüffend einfache Weise und mit minimalem technischen Aufwand verhindern.

Bezugszeichenliste
- A: Ausgangsanschluß
- D1, D2: Dioden
- C, C1, C2: Kondensatoren
- CTL: Steuersignaleingang
- E: Eingangsanschluß
- G: Gateanschluß des Transistors T
- I: Inverter
- R, R1, R2: Widerstände
- T: Feldeffekttransistor
- T1, T3, T4, T5: PMOS-Transistoren
- T2, T6, T7, T8: NMOS-Transistoren

## Patentansprüche

1. Verfahren zum Umschalten eines Feldeffekttransistors (T4; T7) vom sperrenden in den leitenden Zustand oder umgekehrt, wobei das Umschalten unter Anlegen einer zum Umschalten geeigneten Steuerspannung an ein dem Gateanschluß des Feldeffekttransistors vorgeschaltetes RC-Glied (R1, C1; R2, C2) erfolgt,
**dadurch gekennzeichnet,**
**daß** das Umschalten des Feldeffekttransistors unter Verwendung einer Steuerspannung durchgeführt wird, welche zumindest vorübergehend nur geringfügig jenseits der Schwellenspannung (Vth) liegt, die an den Gateanschluß des Feldeffekttransistors angelegt werden muß, um ein Umschalten desselben bewirken zu können.

2. Verfahren nach Anspruch 1,
**dadurchgekennzeichnet,**
daß die Steuerspannung nach dem Umschalten des Feldeffekttransistors (T4; T7) auf eine deutlich jenseits der Schwellenspannung (Vth) liegende Spannung (Ve) gebracht wird.

3. Vorrichtung zum Umschalten eines Feldeffekttransistors (T4; T7) vom sperrenden in den leitenden Zustand oder umgekehrt, wobei das Umschalten unter Anlegen einer zum Umschalten geeigneten Steuerspannung an ein dem Gateanschluß des Feldeffekttransistors vorgeschaltetes RC-Glied (R1, C1; R2, C2) erfolgt,
**dadurch gekennzeichnet,**
**daß** die Vorrichtung dazu ausgelegt ist, das Umschalten des Feldeffekttransistors unter Verwendung einer Steuerspannung durchzuführen, welche zumindest vorübergehend nur geringfügig jenseits der Schwellenspannung (Vth) liegt, die an den Gateanschluß des Feldeffekttransistors angelegt werden muß, um ein Umschalten desselben bewirken zu können.

4. Vorrichtung nach Anspruch 3,
**dadurch gekennzeichnet,**
**daß** die Steuerspannung die Ausgangsspannung eines dem RC-Glied (R1, C1; R2, C2) vorgeschalteten Spannungsteilers (T1, D1, T2; T5, D2, T6) ist.

5. Vorrichtung nach Anspruch 4,
**dadurch gekennzeichnet,**
**daß** der Spannungsteiler (T1, D1, T2; T5, D2, T6) deaktivierbar ist und im deaktivierten Zustand die an ihn angelegte Spannung im wesentlichen unverändert zum RC-Glied (R1, C1; R2, C2) durchschaltet.

6. Vorrichtung nach Anspruch 5,
**dadurch gekennzeichnet,**
**daß** der Spannungsteiler (T1, D1, T2; T5, D2, T6) dazu ausgelegt ist, automatisch deaktiviert zu werden, sobald der Feldeffekttransistor (T4; T7) zumindest teilweise umgeschaltet ist.

## Claims

1. Method for changing over a field-effect transistor (T4; T7) from the off to the on state, or vice versa, the changeover being effected by the application of a control voltage suitable for the changeover to an RC element (R1, C1; R2, C2) connected upstream of the gate terminal of the field-effect transistor,
**characterized**
**in that** the changeover of the field-effect transistor is carried out using a control voltage which at least temporarily only slightly exceeds the threshold voltage (Vth), which has to be applied to the gate terminal of the field-effect transistor in order to be able to effect changeover thereof.

2. Method according to Claim 1,
**characterized**
**in that** after the changeover of the field-effect transistor (T4; T7), the control voltage is brought to a voltage (Ve) considerably exceeding the threshold voltage (Vth).

3. Device for changing over a field-effect transistor (T4; T7) from the off to the on state, or vice versa, the changeover being effected by the application of a control voltage suitable for the changeover to an RC element (R1, C1; R2, C2) connected upstream of the gate terminal of the field-effect transistor,
**characterized**
**in that** the device is designed to carry out the changeover of the field-effect transistor using a control voltage which at least temporarily only slightly exceeds the threshold voltage (Vth), which has to be applied to the gate terminal of the field-effect transistor in order to be able to effect changeover thereof.

4. Device according to Claim 3,
**characterized**
**in that** the control voltage is the output voltage of a voltage divider (T1, D1, T2; T5, D2, T6) connected upstream of the RC elements (R1, C1; R2, C2).

5. Device according to Claim 4,
**characterized**
**in that** the voltage divider (T1, D1, T2; T5, D2, T6) can be deactivated and, in the deactivated state, switches through the voltage that is applied to it essentially unchanged to the RC element (R1, C1; R2, C2).

6. Device according to Claim 5,
**characterized**
**in that** the voltage divider (T1, D1, T2; T5, D2, T6) is designed to be deactivated automatically as soon as the field-effect transistor (T4; T7) has at least partially changed over.

## Revendications

1. Procédé de commutation d'un transistor (T4 ; T7 ) à effet de champ pour le faire passer de l'état bloqué à l'état passant ou inversement, la commutation s'effectuant en appliquant une tension de commande, appropriée à la commutation, à un élément RC (R1, C1 ; R2, C2) monté en amont de la borne de grille du transistor à effet de champ,
**caractérisé**
**en ce qu'**il consiste à effectuer la commutation du transistor à effet de champ en utilisant une tension de commande qui, au moins transitoirement, ne se trouve que peu au-delà de la tension (Vth) de seuil qui doit être appliquée à la borne de grille du transistor à effet de champ pour provoquer une commutation de ce dernier.

2. Procédé suivant la revendication 1, **caractérisé en ce qu'**il consiste à porter la tension de commande, après la commutation du transistor (T4 ; T7) à effet de champ, à une tension (Ve) se trouvant nettement au-delà de la tension (Vth) de seuil.

3. Dispositif de commutation d'un transistor (T4 ; T7) à effet de champ pour le faire passer de l'état bloqué à l'état passant ou inversement, la commutation s'effectuant en appliquant une tension de commande, appropriée à la commutation, à un élément RC (R1, C1 ; R2, C2) monté en amont de la borne de grille du transistor à effet de champ,
**caractérisé**
**en ce que** le dispositif est conçu de façon que la commutation du transistor à effet de champ s'effectue en utilisant une tension de commande qui, au moins transitoirement, ne se trouve que de peu au-delà de la tension (Vth) de seuil qui doit être appliquée à la borne de grille du transistor à effet de champ pour pouvoir provoquer une commutation de ce dernier.

4. Dispositif suivant la revendication 3, **caractérisé en ce que** la tension de commande est la tension de sortie d'un diviseur (T1, D1, T2 ; T5, D2, T6) de tension monté en amont de l'élément RC (R1, C1 ; R2, C2).

5. Dispositif suivant la revendication 4, **caractérisé en ce que** le diviseur (T1, D1, T2 ; T5, D2, T6) de tension peut être désactivé et, à l'état désactivé, applique la tension qui lui est appliquée d'une manière sensiblement inchangée à l'élément RC (R1, C1 ; R2, C2).

6. Dispositif suivant la revendication 5, **caractérisé en ce que** le diviseur (T1, D1, T2 ; T5, D2, T6) de tension est conçu de manière à se désactiver automatiquement dès que le transistor (T4 ; T7) à effet de champ est au moins partiellement commuté.
